# EUROPÄISCHE PATENTANMELDUNG

(11) **EP 1 109 175 A2**
(43) Veröffentlichungstag der Anmeldung: **20.06.2001**
(21) Anmeldenummer: 00403188.6
(22) Anmeldetag: 16.11.2000
(51) Int. Cl.: H01B 7/08

(54) **Flachleiter Bandleitung**

(30) Priorität: 15.12.1999 DE 19960465
(71) Anmelder: Nexans Deutschland Industries AG % Co KG., 41238 Mönchengladbach (DE)
(72) Erfinder: Scheideler, Wolfgang, Dr., 92705 Leuchtenberg (DE); Hemken, Heinz-Jürgen, Dipl-Ing., 52134 Herzogenrath (DE); Steinberg, Helmut, Dr., 92721 Störnstein (DE); Zamzow, Peter, Dipl.-Ing., 44795 Bochum (DE)
(74) Vertreter: Döring, Roger, Dipl.-Ing.

(57) **Zusammenfassung**

Es wird eine Flachleiter-Bandleitung (1) angegeben, bei welcher mindestens zwei flache elektrische Leiter (2) mit rechteckigem Querschnitt mit Abstand parallel zueinander verlaufend in Isoliermaterial (3) eingebettet sind. Zur wirksamen elektrischen Abschirmung ist auf der ganzen äußeren Oberfläche der Bandleitung (1) einschließlich der Seitenkanten (6,7) derselben eine rundum geschlossene, durch Anwendung eines Verfahrens der Oberflächenbeschichtung erzeugte metallische Hülle (4) angebracht, die fest am Isoliermaterial (3) der Bandleitung (1) haftet.

## Beschreibung

Die Erfindung bezieht sich auf eine Flachleiter-Bandleitung, bei welcher mindestens zwei flache elektrische Leiter mit rechteckigem Querschnitt mit Abstand parallel zueinander verlaufend in Isoliermaterial eingebettet sind (DE-AS 26 43 838).

Derartige elektrische Leitungen - im folgenden kurz "FL-BL" genannt - werden mit Vorteil beispielsweise in der Verdrahtungstechnik für unterschiedliche elektrische Geräte und im Automobilbau eingesetzt. Sie haben als ebene Gebilde geringe Abmessungen, so daß sie wenig Platz einnehmen. Da die flachen Leiter fest im Isoliermaterial der FL-BL eingebettet sind, ergibt sich ein guter mechanischer Schutz. Es besteht insbesondere keine Knickgefahr, auch wenn die FL-BL um kleinere Radien gebogen wird. Die FL-BL zeichnet sich daher auch durch gute Biegbarkeit aus. Das gilt auch für die FL-BL nach der eingangs erwähnten DE-AS 26 43 838, bei welcher die Leiter im sogenannten Kaschierverfahren zwischen zwei Folien aus Isoliermaterial eingebettet sind, die fest mit den Leitern und miteinander verbunden sind.

In vielen Fällen ist es erforderlich, die FL-BL mit einem elektrisch wirksamen Schirm auszurüsten. Ein solcher Schirm soll Störsignale unwirksam machen, die von der FL-BL selbst ausgehen, insbesondere aber von außen in die FL-BL eingekoppelt werden könnten (EMV). Als Schirm können beispielsweise Metallfolien aus Aluminum oder Kupfer auf die beiden Flachseiten der FL-BL aufkaschiert werden. Ein solcher Schirm ist an den sehr schmalen Seitenkanten der FL-BL nur durch aufwendige Zusatzmaßnahmen elektrisch wirksam zu verschließen. Eine andere Möglichkeit zur Erzeugung eines Schirms ist das Aufbringen eines Geflechts aus metallischen Drähten, die aus Kupfer oder Aluminum bestehen können. Diese Maßnahme ist sehr aufwenig und zeitraubend.

Der Erfindung liegt die Aufgabe zugrunde, eine Möglichkeit zu schaffen, die eingangs geschilderte FL-BL auf einfache Weise mit einem elektrisch wirksamen Schirm auszurüsten.

Diese Aufgabe wird gemäß der Erfindung dadurch gelöst, daß auf der ganzen äußeren Oberfläche der FL-BL einschließlich der Seitenkanten derselben, eine rundum geschlossene, durch Anwendung eines Verfahrens der Oberflächenbeschichtung erzeugte metallische Hülle angebracht ist, die fest am Isoliermaterial der FL-BL haftet.

Die FL-BL ist durch Einsatz eines an sich bekannten Verfahrens zur physikalischen oder chemischen Oberflächenbeschichtung rundum in eine geschlossene metallische Hülle eingebettet und dadurch mit einem über ihre ganze Länge lückenlosen, elektrisch wirksamen Schirm versehen. Sie ist dadurch in beiden Richtungen für Störsignale "dicht". Diese Tatsache ist für das geometrisch problematische Gebilde "FL-BL" überraschend, da nicht nur die großflächigen Flachseiten derselben, sondern ohne jede Zusatzmaßnahme auch die sehr dünnen Seitenkanten ohne Unterbrechung beschichtet sind. Die metallische Hülle ist daher rundum geschlossen. Da sich das physikalisch oder chemisch aufgebrachte Material der metallischen Hülle, bei dem es sich vorzugsweise um Kupfer handelt, fest mit dem Isoliermaterial der FL-BL verbindet, ist die Hülle automatisch mechanisch geschützt, auch wenn eine nur geringe Schichtdicke für die Hülle verwendet wird. Das gilt insbesondere beim Biegen der FL-BL. Auch bei kleinen Biegeradien bleibt die metallische Hülle fest an der FL-BL haften. Durch die geschlossene metallische Hülle ist die FL-BL nicht nur elektrisch abgeschirmt, sondern gleichzeitig gegen chemische Beanspruchungen und gegen Öl geschützt.

Für die Beschichtung können physikalische Verfahren, wie beispielsweise das PVD-Verfahren (Physical Vapour Deposition), oder chemische Verfahren, wie beispielsweise das CVD-Verfahren (Chemical Vapour Deposition), verwendet werden. In bevorzugter Ausführungsform wird für die Erzeugung der metallischen Hülle das PVD-Verfahren eingesetzt, auf das sich die weiteren Ausführungen beziehen - stellvertretend für alle anderen geeigneten Beschichtungsverfahren. Insbesondere bei Verwendung des PVD-Verfahrens ergibt sich eine auch ohne Haftvermittler fest auf der FL-BL haftende, rundum geschlossene metallische Hülle.

Ein Ausführungsbeispiel des Erfindungsgegenstandes ist in den Zeichnungen dargestellt.

### Es zeigen:

Fig. 1 eine Draufsicht auf eine FL-BL nach der Erfindung.

Fig. 2 einen Schnitt durch Fig. 2 längs der Linie II - II in vergrößerter Darstellung.

Fig. 3 in schematischer Darstellung eine Anordnung zur Beschichtung der FL-BL.

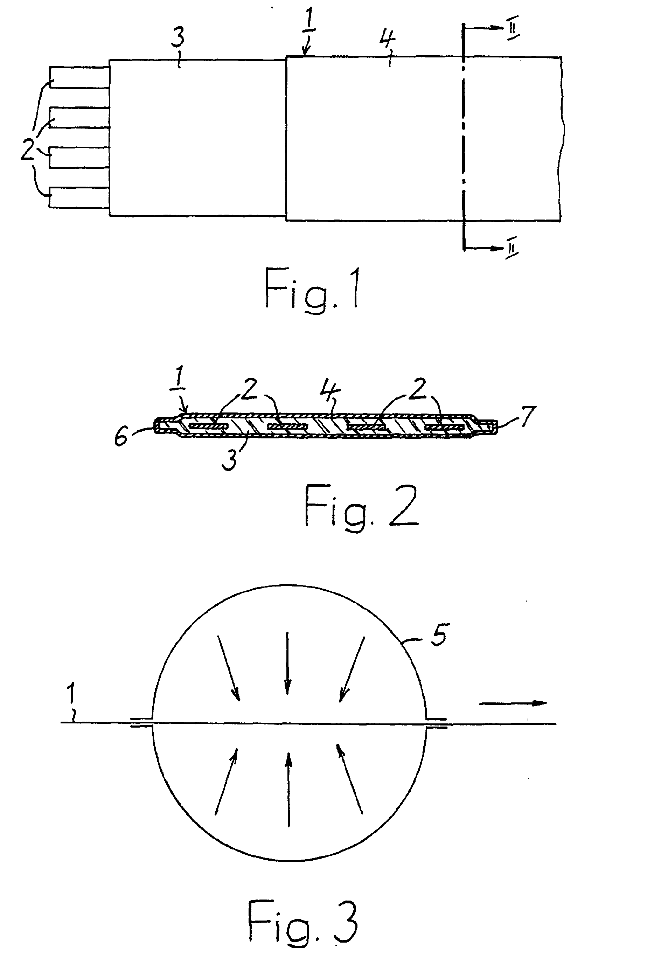

In Fig. 1 ist eine FL-BL 1 dargestellt, die in diesem Ausführungsbeispiel vier flache Leiter 2 mit rechteckigem Querschnitt hat. Die Leiter 2 bestehen aus Kupfer. Sie sind bei herkömmlichen FL-BL etwa 40 µm bis 200 µm dick. Ihre Anzahl ist im üblichen Rahmen beliebig. Es sollen mindestens zwei Leiter 2 sein. Die Leiter 2 sind in eine Isolierung 3 eingebettet, die aus beliebigem Isoliermaterial bestehen kann. In der Isolierung 3 sind die Leiter 2 fest und unverrückbar, mit Abstand parallell zueinander verlaufend angeordnet. Die Isolierung 3 kann beispielsweise aus zwei mit einem Kleber beschichteten Folien bestehen, die im sogenannten Kaschierverfahren von zwei unterschiedlichen Seiten an die Leiter 2 herangebracht und fest miteinander verbunden werden. Die Dicke der Folien beträgt bei üblicher Ausführung einschließlich der Kleberschicht etwa 75 µm bis 90 µm. Die Isolierung 3 kann aber auch durch Extrusion erzeugt werden. Als Isoliermaterial wird in bevorzugter Ausführungsform Polyethylen verwendet.

Über der Isolierung 3 der FL-BL 1 ist eine rundum geschlossene, metallische Hülle 4 angebracht, die durch Einsatz des PVD-Verfahrens erzeugt ist. Eine mit diesem Verfahren auf einer aus Isoliermaterial bestehenden Unterlage aufgebrachte Schicht haftet fest an dem Isoliermaterial. Die Hülle 4 hat eine Dicke, die in bevorzugter Ausführungsform zwischen 500 nm und 2 µm liegt. Das PVD-Verfahren wird im folgenden am Beispiel der Erzeugung einer Hülle 4 beschrieben:

Wenn die Hülle 4 aus Kupfer bestehen soll, wird eine für die Beschichtung einer bekannten Länge einer FL-BL 1 ausreichende Menge Kupfer in eine Vakuumkammer 5 eingebracht, in der es nach ausreichender Erwärmung und nach Anlegen einer elektrischen Spannung kathodisch zerstäubt wird. Dabei werden an einer sogenannten Kathodenkanone ständig Entladungen erzeugt, so daß das Kupfer in eine dampfförmige Phase übergeht. Eine durch die Vakuumkammer 5 hindurchgezogene FL-BL 1 kann so im kontinuerlichen Durchlauf rundum mit Kupfer beschichtet werden.

Die FL-BL 1 durchläuft dabei der Einfachheit halber nicht dargestellte Schleusen, durch welche sichergestellt ist, daß das Vakuum in der Vakuumkammer 5 aufrechterhalten werden kann. Wesentlich ist, daß in der Vakuumkammer 5 nicht nur die flachen Seiten der FL-BL 1 beschichtet werden, sondern auch die schmalen Seitenkanten 6 und 7 derselben. Die Seitenkanten 6 und 7 sind nahezu als scharfkantig zu bezeichnen. Sie haben entsprechend den oben angegebenen Zahlenwerten eine Wandstärke von etwa 150 µm bis 180 µm. Trotz dieser sehr kleinen Anmessungen werden auch die Seitenkanten 6 und 7 lückenlos beschichtet. Die Hülle 4 ist daher ohne weitere Maßnahmen nach dem Verlassen der Vakuumkammer 5 rundum geschlossen.

## Patentansprüche

1. Flachleiter-Bandleitung, bei welcher mindestens zwei flache elektrische Leiter mit rechteckigem Querschnitt mit Abstand parallel zueinander verlaufend in Isoliermaterial eingebettet sind, **dadurch gekennzeichnet**, daß auf der ganzen äußeren Oberfläche der Bandleitung (1) einschließlich der Seitenkanten (6,7) derselben, eine rundum geschlossene, durch Anwendung eines Verfahrens der Oberflächenbeschichtung erzeugte metallische Hülle (4) angebracht ist, die fest am Isoliermaterial (3) der Bandleitung (1) haftet.

2. Verfahren zur Herstellung einer Flachleiter-Bandleitung nach Anspruch 1, **dadurch gekennzeichnet**, daß das Material der metallischen Hülle (4) im kontinuierlichen Durchlauf im PVD-Verfahren auf die fertig isolierte Bandleitung (1) aufgebracht wird.

3. Verfahren zur Herstellung einer Flachleiter-Bandleitung nach Anspruch 1, **dadurch gekennzeichnet**, daß das Material der metallischen Hülle (4) im kontinuierlichen Durchlauf im CVD-Verfahren auf die fertig isolierte Bandleitung (1) aufgebracht wird.
